# EUROPÄISCHE PATENTANMELDUNG

(11) **EP 2 447 995 A1**
(43) Veröffentlichungstag der Anmeldung: **02.05.2012**
(21) Anmeldenummer: 11006867.3
(22) Anmeldetag: 23.08.2011
(51) Int. Cl.: H01L 23/58

(54) **Gesicherter elektronischer integrierter Schaltkreis**

(30) Priorität: 23.08.2010 DE 102010035163
(71) Anmelder: PolyIC GmbH & Co. KG, 90763 Fürth (DE)
(72) Erfinder: Ullmann, Andreas, 90513 Zirndorf (DE); Klusmann, Matthias, 90443 Nürnberg (DE)
(74) Vertreter: Zinsinger, Norbert

(57) **Zusammenfassung**

Die Erfindung betrifft Schaltkreise der Halbleitertechnologie, umfassend einen elektronischen integrierten Schaltkreis, insbesondere auch Schaltkreise der herkömmlichen siliziumbasierten Halbleitertechnologie, die eine verbesserte Sicherung gegen Diebstahl und/oder unbefugtes Auslesen haben, dadurch dass sie unlösbar mit einem organisch basierten elektronischen Schaltkreis verbunden sind, der beim Ablösen und Entfernen des siliziumbasierten Halbleiterschaltkreises zerstört werden würde.

## Beschreibung

Die Erfindung betrifft siliziumbasierte Schaltkreise in der Halbleitertechnologie, die eine verbesserte Sicherung gegen Entfernen haben.

Schaltkreise kommen praktisch in und an allen Geräten vor, zum Teil steuern sie die Geräte, zum Teil kommunizieren die elektronischen integrierte Schaltkreise drahtlos oder leitungsgebunden mit den sie umgebenden Kommunikationsnetzen.

Teilweise ist es wirtschaftlich interessant, die siliziumbasierten Schaltkreise vom ursprünglich dazugehörenden Gerät zu entfernen, ohne dabei dessen Funktionsweise zu zerstören.

Dies passiert beispielsweise für den unerlaubten Nachbau von Geräten und/oder wenn das Gerät unbrauchbar ist und die Herstellungskosten für neue siliziumbasierte Schaltkreise gespart werden können.

Für die Hersteller der Geräte ist es daher aus verschiedenen Gründen interessant, eine Sicherung gegen Entfernen der Schaltkreise vorzusehen.

In der Regel bilden Schaltkreise "das Herz" des Gerätes, so dass, sobald die Schaltkreise des Gerätes ausgelesen und verstanden sind, die Funktionsweise des Gerätes auch klar ist.

Durch einfaches Abziehen, Delaminieren, Ablösen oder Abschmelzen (Punktlöten) der sie umgebenden Kontakte können siliziumbasierte Schaltkreise bislang aus ihrer ursprünglichen Anwendung, oft auch ohne irgendeinen Schaden am elektronischen Bauteil anzurichten, entfernt werden. Dadurch wird ein Missbrauch, wie oben beschrieben, ermöglicht.

Aufgabe der Erfindung ist daher die Schaffung einer Sicherung für siliziumbasierte Schaltkreise auf/in/an Geräten aller Art.

Die Lösung der Aufgabe und Gegenstand der Erfindung wird durch die vorliegende Beschreibung, die Ansprüche und die Figuren offenbart.

Dementsprechend ist Gegenstand der Erfindung ein kombinierter elektronischer Schaltkreis, einen siliziumbasierten ersten Teil und einen organisch elektronisch basierten zweiten Teil umfassend, wobei eine Kontaktierung zwischen den beiden Teilen vorgesehen ist, durch die der siliziumbasierte Schaltkreis an den organisch basierten Schaltkreis angeschlossen ist, und die beiden Schaltkreise so aufeinander abgestimmt sind, dass der siliziumbasierte Schaltkreis funktionsunfähig wird, wenn der organisch basierte Schaltkreis und/oder der Kontakt zwischen dem organisch basierten Schaltkreis und dem siliziumbasierten Schaltkreis beschädigt ist.

Der Erfindung liegt die Erkenntnis zugrunde, dass die Art der äußeren Einwirkung, die nötig ist, um einen siliziumbasierten Schaltkreis zu entfernen, immer ausreicht, um einen organischen elektronischen Schaltkreis zu zerstören.

Als "organische Elektronik oder organischer elektronischer Baustein", "organisch basierter Schaltkreis" wird hier ein elektronisches Bauelement/ Schaltkreis im Schichtaufbau bezeichnet, das/der eine aktive Schicht aus organischem Material umfasst, wobei beispielsweise eine leitende, halbleitende und/oder eine isolierende Schicht aus organischem Material sein kann. Beispiele für aktive organische elektronische Bauelemente, wie sie hier unter dem Begriff "organisch basierter Schaltkreis" zusammengefasst werden, sind Transistor, Diode, Halbleiterdiode und/oder integrierte Schaltungen. Diese Bauelemente können alle vorliegend unter dem Begriff "organisch basierter Schaltkreis" oder "aktives organisch basiertes Bauelement" zusammengefasst sein.

Als "organisches Material" wird hier jedes Material bezeichnet, das nicht unter die typischen Materialien der siliziumbasierten Halbleitertechnologie fällt, also beispielsweise alle polymeren, durch Druckverfahren aufbringbaren leitenden, halbleitenden und isolierenden Schicht- und/oder Beschichtungsmaterialien, die zum Aufbau beispielsweise organischer Feldeffekttransistoren, wie sie bereits beschrieben sind, eingesetzt werden. Ebenso fallen auch alle durch Sputter- und/oder Verdampfungstechniken applizierbare Verbindungstypen unter diesen Begriff. Schließlich sind auch metallorganische, hybridorganische, anorganisch-organisch kombinierte Materialklassen unter diesem Begriff hier subsumiert. Eine Abgrenzung findet praktisch nur zur siliziumbasierten traditionellen Halbleitertechnologie statt, alles andere wird unter "organisch basiert" zusammengefasst.

Gemäß der Erfindung wird beispielsweise ein Silizium basierter Schaltkreis durch Kontakte mit externen Strom/Spannungsquellen verbunden und versorgt dann seinerseits den organischen elektronischen Schaltkreis durch die Kontakte zwischen den beiden Schaltkreisen mit Strom und/oder Spannung.

Beispielsweise kann der siliziumbasierte Schaltkreis in den organisch basierten Schaltkreis so integriert werden, dass der siliziumbasierte Schaltkreis auf dem gleichen Substrat wie der organisch basierte Schaltkreis aufgebaut ist, angeordnet ist. Das kann beispielsweise ein Substrat sein, auf dem die organisch basierte elektronische Schaltung durch Drucken hergestellt wurde.

Bedingt durch den dünnen Schichtaufbau des organischen elektronischen Schaltkreises (die Schichtdicken können bis zu einigen Nanometer oder einigen 10 bis 100 Nanometer reduziert werden) beeinträchtigt der Zusatz eines organischen elektronischen Schaltkreises die Anbringung eines Silizium basierten Schaltkreises auf oder an oder in einem Gerät nicht oder nur unwesentlich.

Durch die Flexibilität eines organischen elektronischen Schaltkreises, der beispielsweise auf einer flexiblen und/oder transparenten Folie als Substrat, beispielsweise einer herkömmlichen Polyethylenfolie und/oder eine Polycarbonfolie, aufgebaut ist, kann dieser ohne Beeinträchtigung überall aufgebracht werden, ohne Gewicht des Gerätes, Optik oder Kompaktheit zu beeinträchtigen.

Andererseits sind die einzelnen Schichten, die zum Aufbau der organisch basierten Elektronik nötig sind, derart empfindlich, dass sie, wenn eine gewisse Überbeanspruchung thermischer oder mechanischer Art erfolgt, brechen oder zerstört werden. Dies geschieht beispielsweise durch das beabsichtigte unbefugte, also vom Hersteller nicht vorgesehene Ablösen und Entfernen der siliziumbasierten Schaltkreise. Die mit dem Siliziumbasierten Schaltkreis durch direkten Kontakt verbundene organisch basierte Elektronik wird dabei zerstört und ein Nachbau und/oder Datendiebstahl aus siliziumbasierten Schaltkreisen wird dadurch unmöglich oder zumindest erschwert.

Im Folgenden wird die Erfindung noch anhand von Figuren, die Ausführungsformen der Erfindung zeigen, näher erläutert.
Figur 1 zeigt den Aufbau eines kombinierten Schaltkreises in gestapelter Form im Querschnitt
Figur 2 zeigt den Aufbau eines kombinierten Schaltkreises bei dem der elektronisch basierte Teil des Schaltkreises und der siliziumbasierte Teil des Schaltkreises flächig angeordnet sind, im Querschnitt,
Figur 3 zeigt eine Draufsicht auf einen kombinierten Schaltkreis gemäß dem in Figur 2 im Querschnitt gezeigten Schaltkreis.

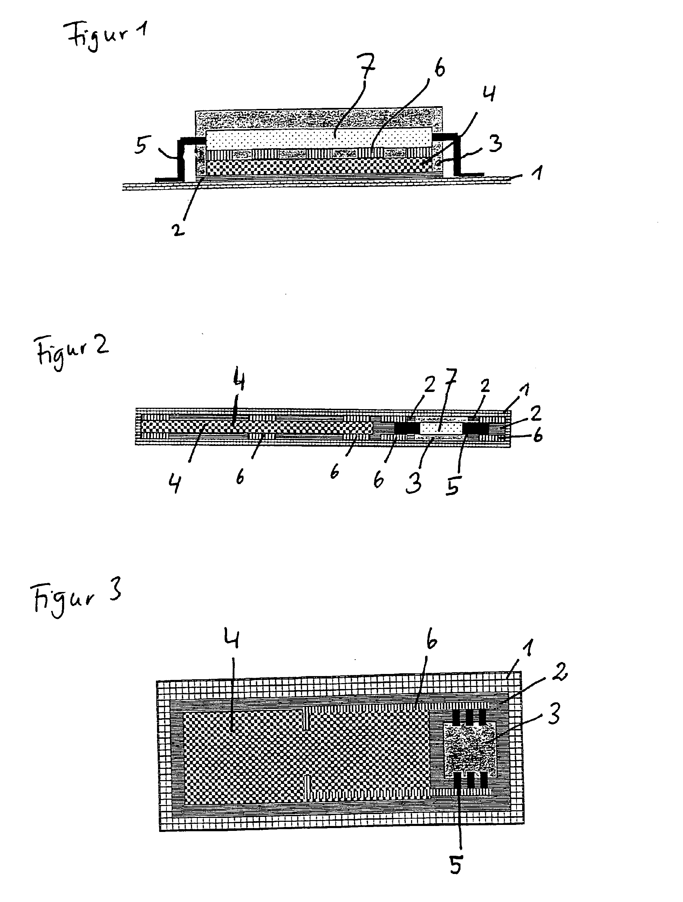

Figur 1 zeigt einen Querschnitt durch einen kombinierten Schaltkreis mit einem organischen elektronischen Teil 4 und einem siliziumbasierten elektronischen Teil 7 in gestapelter Form und beide unter einem Gehäuse 3 angeordnet, gemäß einer Ausführungsform der vorliegenden Erfindung, dar.

Zu erkennen ist in Figur 1 unten das Substrat 1, beispielsweise eine flexible Folie oder auch Glas, Kunststoff, Metall, je nach Anwendung.

Auf dem Substrat 1 ist bei der hier gezeigten Ausführungsform ein Haftvermittler 2 aufgebracht, auf dem der eigentliche Aufbau der organischen elektronischen Schaltung 4 angeordnet ist. Die Schaltkreise werden durch eine Gehäuse 3 das an den Haftvermittler 2 anschließt, von der Umgebung abgeschirmt. Das Gehäuse 3 kann ebenso gut direkt an das Substrat 1 wie an den Haftvermittler 2 anschließen.

Die organische elektronische Schaltung 4 ist über zweite Kontakte 6 mit der siliziumbasierten Schaltung 7 verbunden und an diese angeschlossen. Die siliziumbasierte Schaltung wiederum ist über erste Kontakte 5 durch das Gehäuse 3 hindurch beispielsweise mit externen Strom- und/oder Spannungsquellen (nicht gezeigt) verbunden.

Dieser Aufbau schützt die siliziumbasierte Schaltung vor unbefugter Entfernung dadurch, dass bei der Ablösung der siliziumbasierten Schaltung die Kontakte zu der organischen elektronischen Schaltung zwangsläufig brechen und vermutlich auch die ersten Schichten der organisch basierten Schaltung zerstört oder beschädigt werden. Die Funktionalität des siliziumbasierten Schaltkreises ist gemäß der Erfindung so abhängig von der organisch basierten Schaltung, dass bei deren Beschädigung die Funktionalität des gesamten siliziumbasierten Schaltkreises lahm gelegt wird.

Die siliziumbasierten Schaltkreise (7) verlieren also ihre Funktion, sobald das Siegel gebrochen wird. Dies ist ein Schutz der Daten, die in dem siliziumbasierten Schaltkreis (7) gespeichert sind und auch eine Gewährleistung, dass in spezifischen elektronischen Schaltungen nur neuwertige Bauteile eingesetzt werden können, da die alten durch die Kombination mit der organischen Elektronik beim Entfernen unbrauchbar werden.

Figur 2 zeigt eine alternative Ausführungsform der Erfindung: Umgeben von einer Verkapselung 1 erkennt man zwei elektronische Schaltkreise 4 und 7, wobei ein großflächiger organisch elektronisch basierter Schaltkreis 4 auf der linken Seite und ein vergleichsweise kompakt gebauter elektronischer siliziumbasierter Schaltkreis 7 auf der rechten Bildseite gezeigt sind. Den siliziumbasierten Schaltkreis 7 umgeben neben einem Haftvermittler 2 die ersten Kontakte 5, die an die zweiten Kontakte 6 des organischen elektronischen Schaltkreises 4 anknüpfen. Der siliziumbasierte Schaltkreis 7 ist außer von den ersten Kontakten 5 auch noch von einem Gehäuse 3 umgeben. Diese Ausführungsform kann beispielsweise auch in Form einer Kunststoffkarte eingesetzt werden, beim Entfernen oder Delaminieren der Karte ist der siliziumbasierte Schaltkreis (7) nicht mehr auslesbar.

Figur 3 zeigt den aus Figur 2 bekannten Aufbau in der Draufsicht. Wieder erkennt man Verkapselung 1 und den Haftvermittler 2, die siliziumbasierte Schaltung 7, im Gehäuse 3 nicht sichtbar in der Draufsicht, und die organisch basierte elektronische Schaltung 4 mit den zweiten Kontakten 6 wie ein Rahmen umgibt. Die ersten Kontakte 5 leiten vom Gehäuse 3 der siliziumbasierten elektronischen Schaltung direkt zu den zweiten Kontakten 6 der organisch basierten Schaltung 4.

Die Erfindung offenbart praktisch ein "elektronisches Siegel" das verschiedenste Anwendungen erschließt.

Für das elektronische Siegel sind beispielsweise folgende Anwendungen vorgesehen:
Garantieschutz von Geräten: Hersteller vergeben oft Garantieschutz für Geräte, bei denen die eingesetzte Siliziumtechnologie kontaktloses oder kontaktgebundenes Auslesen ermöglicht, unter der Bedingung, dass beispielsweise das Gehäuse nicht geöffnet wurde. Durch eine Anbringung eines elektronischen Siegels wie erfindungsgemäß offenbart, kann eindeutig ein unbefugtes Öffnen des Gehäuses und damit ein Garantieverstoß nachgewiesen werden.

Alarmsicherung von Gebäuden, ungenehmigtes Öffnen von Verpackungen:
Bei Anwendungen, wo ein siliziumbasierter Schaltkreis einen kontaktlosen Anschluss an drahtlose Kommunikationsnetze ermöglicht, kann ein elektronisches Siegel gemäß der Erfindung unabhängig von bestehender Infrastruktur eingesetzt werden. Sobald das elektronische Siegel gebrochen wird, wird eine Nachricht an den Anbringer übermittelt.

Beispielsweise kann ein elektronisches Siegel in Form einer Karte, wie gemäß Figuren 2 und 3 beschrieben, beispielsweise in Form einer Kunststoffkarte, als Schutz vor aktiven oder passiven Transponderkarten eingesetzt werden. Dabei bewirkt der organisch basierte Schaltkreis, dass der siliziumbasierte Schaltkreis nach dem Delaminieren der Karte nicht mehr auslesbar ist. Beispielsweise kann das Signal des organisch basierten Schaltkreises dazu genutzt werden, um einem kartenspezifischen Verschlüsselungsalgorithmus für die Datenübertragung zu generieren.

Beispielsweise wird ein bestehender siliziumbasierter Schaltkreis oder eine bestehende Silizium-Schaltung durch eine organisch basierte Schaltung ergänzt.

Mit Hilfe der organisch basierten Schaltung ist der siliziumbasierte Schaltkreis und/oder die siliziumbasierte Schaltung in der Lage eine Verschlüsselung zu erstellen, die bedingt durch den Schaltungsaufbau der organisch basierten Elektronik einzigartig ist.

Für das Erstellen der Verschlüsselung, die nicht von außen beeinflusst werden kann, wird ein von der organisch basierten Schaltung erzeugtes Signal verwendet.

Das analoge Signal von der organisch basierten Schaltung wird beispielsweise durch einen in der siliziumbasierten Schaltung befindlichen Analog- Digital- Wandler digitalisiert und aus diesen Werten ein Schlüssel errechnet. Mit Hilfe dieses Schlüssels wird die siliziumbasierte Schaltung erst funktionsfähig.

Wird die organisch basierte Schaltung zerstört, ist die siliziumbasierte Schaltung nicht mehr funktionsfähig, weil sie keinen Schlüssel mehr generieren kann.

Das Erstellen des Schlüssels erfolgt beispielsweise bei der Herstellung und lässt sich nachträglich nicht ändern.

Durch die Erfindung wird es erstmals möglich, eine Art Versiegelung der siliziumbasierten Elektronik eines Gerätes zu schaffen. Wird das Siegel, also die organisch basierte Elektronik durch Entfernen der siliziumbasierten Elektronik gebrochen und/oder beschädigt, dann kann die siliziumbasierte Elektronik weder ausgelesen noch weiterverwendet werden.

Ebenfalls ausgeschlossen wird ein Wiederherstellen des Ausgangszustandes, da die organisch basierte Elektronik in wirtschaftlich vertretbarem Rahmen nicht reparabel ist.

Durch die vorliegende Erfindung werden erstmals Schaltkreise der Halbleitertechnologie -insbesondere auch Schaltkreise der herkömmlichen siliziumbasierten Halbleitertechnologie, bekannt, die eine verbesserte Sicherung gegen Diebstahl und/oder unbefugtes Auslesen haben, dadurch dass sie unlösbar und funktionell abhängig mit einem organisch basierten elektronischen Schaltkreis verbunden sind, der beim Ablösen und Entfernen des siliziumbasierten Halbleiterschaltkreises kaputt geht.

## Patentansprüche

1. Kombinierter elektronischer Schaltkreis, einen siliziumbasierten ersten Teil und einen organisch elektronisch basierten zweiten Teil umfassend, wobei eine Kontaktierung zwischen den beiden Teilen vorgesehen ist, durch die der siliziumbasierte Schaltkreis an den organisch basierten Schaltkreis angeschlossen ist, und die beiden Schaltkreise so aufeinander abgestimmt sind, dass der siliziumbasierte Schaltkreis funktionsunfähig wird, wenn der organisch basierte Schaltkreis und/oder der Kontakt zwischen dem organisch basierten Schaltkreis und dem siliziumbasierten Schaltkreis beschädigt ist, wobei der organisch basierte Schaltkreis ein aktives organisch basiertes elektronisches Bauelement umfasst.

2. Kombinierter elektronischer Schaltkreis nach Anspruch 1, wobei der siliziumbasierte erste Teil (7) innerhalb eines Gehäuses (3) angeordnet ist.

3. Kombinierter elektronischer Schaltkreis nach einem der vorstehenden Ansprüche 1 oder 2, wobei der organische elektronisch basierte zweite Teil (4) in einem Gehäuse (3) mit dem siliziumbasierten ersten Teil (7) angeordnet ist.

4. Kombinierter elektronischer Schaltkreis nach einem der vorstehenden Ansprüche, wobei der organisch elektronisch basierte Teil (4) mit dem siliziumbasierten Teil (7) auf einer Ebene angeordnet ist.

5. Verwendung eines kombinierten elektronischen Schaltkreises nach einem der vorstehenden Ansprüche beim Garantieschutz von Geräten und/oder bei der Alarmsicherung von geschlossenen Türen, Verpackungen und Gehäusen.

6. Verwendung eines kombinierten elektronischen Schaltkreises nach einem der vorstehenden Ansprüche als Karte beim Schutz von aktiven oder passiven Transponderkarten.

7. Verwendung eines kombinierten elektronischen Schaltkreises beim Schutz gespeicherter Daten.
